# EUROPEAN PATENT SPECIFICATION

(11) **EP 1 760 799 B1**
(45) Date of publication and mention of the grant of the patent: **09.06.2010**
(21) Application number: 06019653.2
(22) Date of filing: 27.04.2001
(51) Int. Cl.: H01L 51/00, C08F 38/00, C09K 11/06, C08G 61/02

(54) **Organic luminous material and organic light-emitting device**
Organischer lumineszenter Stoff und organisches lichtemittierendes Bauelement
Matière organique lumineuse et dispositif organique émetteur de lumière

(30) Priority: 27.04.2000 JP 2000128364; 22.09.2000 JP 2000288692; 24.04.2001 JP 2001125359
(43) Date of publication of application: 07.03.2007
(62) Divisional of application: 01303861.7
(73) Proprietor: Fujitsu Ltd., Kawasaki-shi, Kanagawa 211-8588 (JP)
(72) Inventor: Yoshikawa, Kota Fujitsu Limited, Kawasaki-shi Kanagawa 211-8588 (JP); Kijima, Masashi, Tsukuba-shi Ibaraki (JP); Shirakawa, Hideki, Yokohama-shi Kanagawa (JP); Kinoshita, Ikuo, Tsukuba-shi Ibaraki (JP)
(74) Representative: Fenlon, Christine Lesley

(56) References cited:
- EP-A- 0 243 807
- EP-A- 0 383 621
- DE-A1- 4 339 646
- US-A- 4 895 975
- X.T. TAO ET.AL.: "Novel main-chain poly-carbazoles as hole and electron transport materials in polymer light-emitting diodes" APPL. PHYS. LETT., vol. 71, no. 14, 1997, pages 1921-1923, XP002339411
- REMMERS M ET AL: "THE OPTICAL, ELECTRONIC, AND ELECTROLUMINESCENT PROPERTIES OF NOVELPOLY(P-PHENYLENE)-RELATED POLYMERS" MACROMOLECULES, AMERICAN CHEMICAL SOCIETY. EASTON, US, vol. 29, no. 23, 4 November 1996 (1996-11-04), pages 7432-7445, XP000631108 ISSN: 0024-9297
- S. TASCH ET.AL.: "Efficient white light-emitting diodes realized with new processable blends of conjugated polymers" APPL. PHYS. LETT., vol. 71, no. 20, 1997, pages 2883-2885, XP002339412
- PATENT ABSTRACTS OF JAPAN vol. 013, no. 339 (C-624), 31 July 1989 (1989-07-31) & JP 01 115928 A (AGENCY OF IND SCIENCE & TECHNOL), 9 May 1989 (1989-05-09)
- PATENT ABSTRACTS OF JAPAN vol. 013, no. 339 (C-624), 31 July 1989 (1989-07-31) & JP 01 115929 A (AGENCY OF IND SCIENCE & TECHNOL), 9 May 1989 (1989-05-09)
- K. A. BUNTEN, A. K. KAKKAR: "Synthesis,optical absorption, fluorescence, quantum efficiency, and electrical conductivity studies of pyridine/pyridinium dialkynyl organic and Pt(II)-sigma- acetylide monomers and polymers" MACROMOLECULES, vol. 29, 1996, pages 2885-2893, XP002350556
- HOLZER W ET AL: "Excitation intensity-dependent fluorescence behaviour of some luminescent polymers" POLYMER, ELSEVIER SCIENCE PUBLISHERS B.V, GB, vol. 39, no. 16, July 1998 (1998-07), pages 3651-3656, XP004120980 ISSN: 0032-3861
- YANG M ET AL: "Characterization and fluorescence properties of thiophene-modified pi-conjugated nickel poly-yne polymers" POLYMER, ELSEVIER SCIENCE PUBLISHERS B.V, GB, vol. 40, no. 11, May 1999 (1999-05), pages 3203-3209, XP004157673 ISSN: 0032-3861
- T. HATTORI ET.AL.: "Photoinduced absorption and luminescence in polydiacetylenes" J.PHS.C: SOLID STATE PHYS., vol. 17, 1984, pages L881-L888, XP002339413

## Description

The present invention relates to an organic luminous material and an organic light-emitting device and, more particularly, to an organic light-emitting device like an organic electroluminescence (EL) device employing such material.

In recent years, the research and development of an organic EL device applied to a flat display panel, a mobile display device, etc. has been vigorously pursued. A display device employing an organic EL device can provide high brightness and full color display by low voltage driving.

In addition, a display device consisting of an organic EL devices has features different from a liquid crystal display (LCD). For example, there can be provided a light weight and low cost product that has no viewing angle dependence because it is a spontaneously emissive display, does not need back lights because of the high contrast, has a quick response speed, has an easy film formation characteristic, and withstands impact since the overall device is constructed from solid state elements.

An organic EL device has a structure made up of lower electrode formed of transparent conductive material, an organic thin film (luminous layer), and an upper electrode formed of magnesium, potassium, etc. formed in sequence on the glass substrate, for example. The thickness of the overall structure can be reduced up to about several mm. Then, light is emitted from the luminous layer by applying a DC voltage between the lower electrode and the upper electrode, and this light is passed through the lower electrode and the glass substrate to output to the outside. The organic EL device is an injection electroluminescence device that increases the number of carriers in operation by injecting the carriers from the electrode to thus emit light by recombination. Sometimes the organic EL device is also called an organic LED.

As the luminous material employed in the organic thin film of the organic EL device, there are used monomer materials and polymer materials. Normally a film of monomer material is formed by the vacuum evaporation method, and normally a film of polymer material is formed by a coating method. Coating methods are practical in device formation because expensive equipment is not needed.

It is known to employ PPV (poly p-phenylenevinylene) as the polymer material. An EL device employing such material is set forth in Patent Application Publication (KOKAI) Hei 10-326675, for example.

"Synthesis, Optical Absorption, Fluorescence, Quantum Efficiency, and Electrical Conductivity Studies of Pyridine/Pyridinium Dialkynyl Organic and Pt (II)-σ-Acetylide Monomers and Polymers" by Kevin A. Bunten and Ashok K. Kakkar, Macromolecules 1996, 29. 2885-2893, discloses the synthesis of a variety of 2.5- and 2.6-diethynylpyridine based organic and Pt^{II}-σ-acetylide monomers and polymers. Quarternization of pyridine nitrogen via solution nucleophilic substitution reactions with methyl iodide and methyl triflates is said to yield stable pyridinium analogs, accompanied by strong red shifts in the UV-vis absorption spectra.

"Efficient white light-emitting diodes realized with new processable blends of conjugated polymers" by S. Tasch et al, Appl. Phys. Lett. 71(20), 17 November 1997, pp 2883 to 2885, (XP-002339412), discloses a method for producing white light-emitting polymer diodes based on a blend of two polymers, the white light emission being composed of a broad blue emission of laddertype (polyparaphenylene) (*m*-LPPP) and a red-orange emission of poly(perylene-co-diethynylbenzene) (PPDB). The red-orange electroluminescence emission is promoted by an excitation energy and charge transfer from *m*-LPPP to the PPDB. A concentration of 0.05% PPDB in the polymer blend is required in order to obtain white light emission.

A conjugated polymer material such as PPV employed as the luminous layer in the prior art is in a highly crystalline state at normal temperature, unlike a normal polymer material.

Accordingly, if such conjugated polymer material is formed on the substrate, unevenness readily occurs on the surface of the luminous layer made of the polymer.

If a voltage is applied between the lower electrode and the upper electrode under conditions such that unevenness is present on the surface of the luminous layer, the electric field is readily concentrated in the concave portion of the surface of the luminous layer. Thus, there is the possibility that the luminous layer is destroyed by the electric field, and then a short-circuit is caused between the lower electrode and the upper electrode.

Also, since the luminous polymer layer in the prior art, which is readily crystallised, is insoluble in the organic solvent, treatment must be applied, e.g., the polymer must be mixed into the organic solvent while being heated, when the polymer is coated on the substrate, and thus it is not easy to handle the polymer. In addition, even if the conjugated polymer in the prior art is dissolved in the organic solvent, such polymer is still readily crystallized after cooling.

It is an object of the present invention to provide a light-emitting device having a luminous layer formed of polymer material that can be highly planarized and has a solubility in organic solvents higher than that of polymer film material in the prior art.

According to a first aspect of the present invention, there is provided an organic luminous material having the general formula 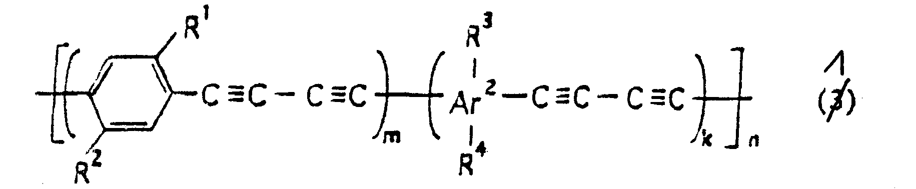 where Ar² denotes an arylene group, R¹, R², R³ and R⁴ denotes substituents, which can be the same or different or some of which can be the same and other(s) different and m and k together denote the copolymerization ratio and n denotes the degree of polymerisation; wherein an aromatic ring comprised by the arylene group is any one of thiophene, anthracene, pyridine, phenol, aniline and derivatives thereof, and the said substituents are selected from hydrogen, alkyl, alkoxy, carboxyl, cyano, phenyl, biphenyl and cyclohexylphenyl; and wherein 0<m<1, m+k=1.

According to a second aspect of the present invention there is provided an organic light-emitting device comprising: a lower electrode; a luminous layer formed on the lower electrode, which is the organic luminous material according to the first aspect of the present invention; and an upper electrode formed on the luminous layer.

It is preferable that n is set to 0<n<0.9. The terms "aryl" and "aromatic ring" used herein, unless otherwise indicated, denotes both carbocyclic and heterocyclic optionally substituted single and fused ring systems.

The organic luminous material given by 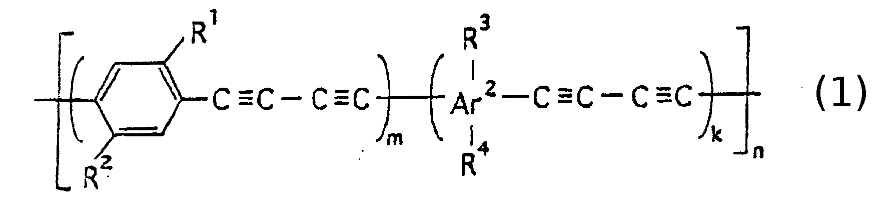 is a luminous material that emits light in or near the red color luminous wavelength band.

For a better understanding of the invention, and to show how the same may be carried into effect, reference will now be made, by way of example, to the accompanying drawings, in which:-
FIGS.1A to 1D are sectional views showing steps in manufacturing an organic EL device;
FIG.2 is a graph showing the change of fluorescent spectrum of a luminous layer employed in an organic EL device during the manufacturing process;
FIG.3 is a graph showing the EL spectrum change with respect to the luminous wavelength emitted by the luminous layer employed in an organic EL device; and
FIG.4 is a graph showing the fluorescent spectrum of a red color luminous layer employed in an organic EL device according to the present invention.

An embodiment of the present invention will be explained, with reference to the accompanying drawings hereinafter.

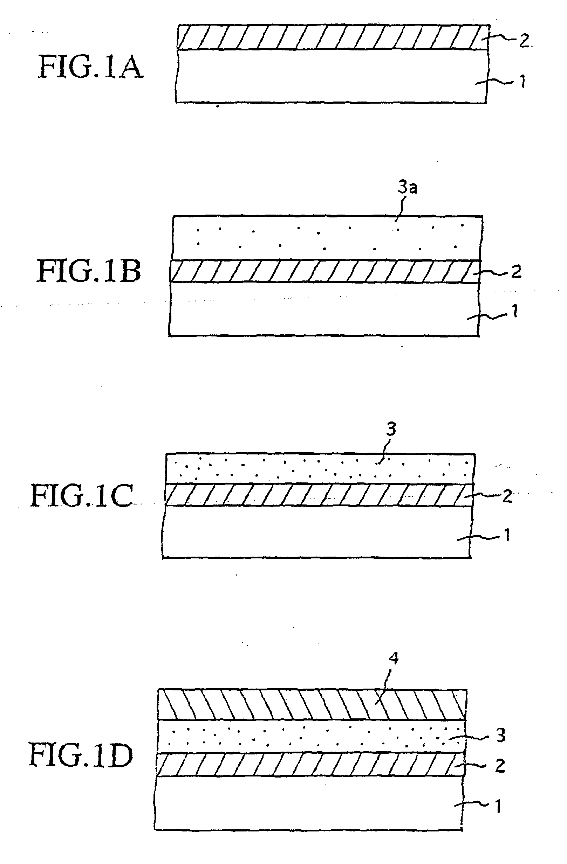

FIGS.1A to 1D are sectional views showing steps in manufacturing an organic EL device.

In FIG.1A, an ITO (indium tin oxide) film of 200 nm thickness is formed on a glass (transparent) substrate 1 as a lower electrode (anode) 2 by the sputtering method. The ITO Film is exposed to oxygen, an ozone plasma, or the like to clean the surface.

The constituent material of the lower electrode 2 is not limited to ITO. Transparent conductive materials such as IDIXO (indium zinc oxide) and others may be employed.

Then, the polymer given by a following chemical formula (2) is formed as a luminous layer 3 on the lower electrode 2 by the spin coating method to have a thickness of 150 nm, for example. For example, in the chemical formula (2), n=0.5.

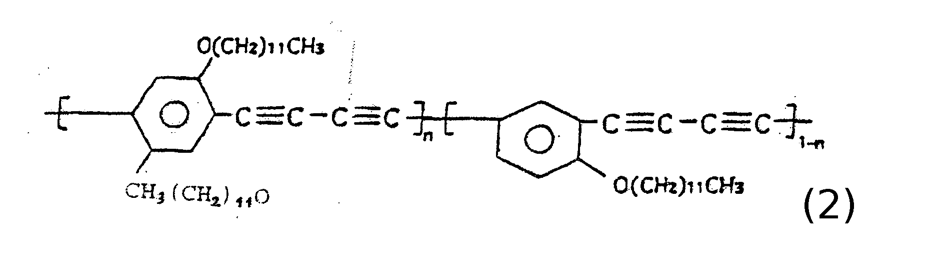

In the spin coating of the polymer, a solution is prepared by dissolving the polymer in a solvent, e.g., chloroform (CHCl₃) at ambient temperature. Then, as shown in FIG.1B, the solution 3a is coated on the lower electrode 2, and then the solvent is removed by drying. The drying temperature is set to more than the vaporisation temperature of the solvent but less than 150°C. If the solvent is removed at 150°C, the drying time is set to about 30 minutes. The preferable drying conditions are drying temperature of 90°C and drying time of 60 minutes.

As shown in FIG.1C, the polymer left on the lower electrode 2 and having the chemical formula (2) is employed as the luminous layer 3.

Then, as shown in FIG.1D, a magnesium silver (MgAg) layer of 300 nm thickness is formed as an upper electrode (cathode) 4 on the luminous layer 3 by the co-evaporation method. This co-evaporation method used to form the magnesium silver is such that separate evaporation sources for each constituent element are arranged in the evaporation chamber and the elements are evaporated toward the same substrate to form the alloy. In this example, the upper electrode 4 is formed of a MgAg film in which the magnesium and the silver are alloyed at the ratio of 1:10. In this case, the upper electrode 4 may be grown during the evaporation while effecting patterning of the upper electrode 4 by placing a metal mask between the evaporation sources and the substrate. In addition, as the material of the upper electrode 4, alkali metals and alkaline earth metals, singly or in combinations with each other or other metals such as Na, NaK, Mg, Li, CaMg/Cu mixture, Mg/In alloy, etc. may be employed.

When producing the light-emitting device by the above steps, if the current is supplied by applying a voltage while setting the lower electrode 2 to the positive side and the upper electrode 4 to the negative side, green light is emitted from the light-emitting device, The light is passed through the lower electrode 2 and the glass substrate 1 and then emitted to the outside.

In the above example, since the polymer of chemical formula (2) has low crystallinity at ambient temperature and has good solubility in solvent used, the surface of the polymer left after drying is flat unlike in the prior art. Thus, short-circuiting between the upper electrode and the lower electrode can be prevented and the yield of the device can be improved.

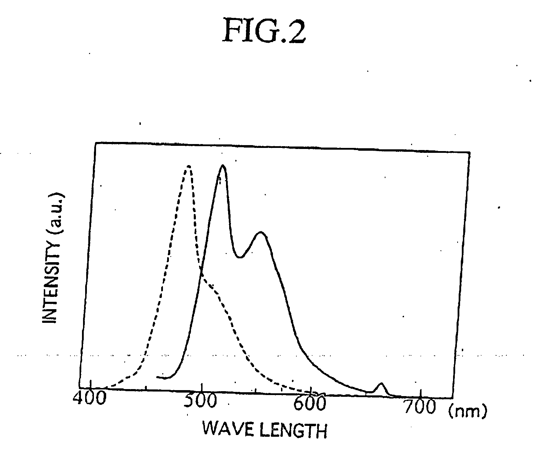

The fluorescent spectrum produced when the polymer of chemical formula (2) is dissolved in the chloroform has a profile indicated by a broken line in FIG.2, and the fluorescent spectrum of the polymer in the film state after the chloroform is removed has a profile indicated by a solid line in FIG.2. In other words, it is to be understood that the polymer in the film state can emit light in the range of 500 to 550 nm.

A method of synthesizing the polymer given by the chemical formula (2) will be explained hereunder.

First, 150 mg (1.5 mmol) of copper (I) chloride and 180 mg (1.5 mmol) of N,N,N',N'-tetramethylethylenediamine (TMEDA) are added in 180ml of tetrahydrofuran (THF). Then, the catalyst is formed by supplying oxygen to the mixture for 10 minutes.

1.48 g (3 mmol) of 2,5-didodecyloxy-1,4-diethynylbenzene and 0.93 g (3 mmol) 4-dodecyloxy-1,3-diethynylbenzene are dissolved in 180ml tetrahydrofuran solution, and then this resultant solution is added to the THF solution containing the above catalyst. Then, substances in the resulting mixture are caused to react with each other under an oxygen atmosphere for two days. This reaction is an oxidative condensation polymerisation reaction.

The 2,5-didodecyloxy-1,4-diethynylbenzene is indicated by a following chemical formula (3).

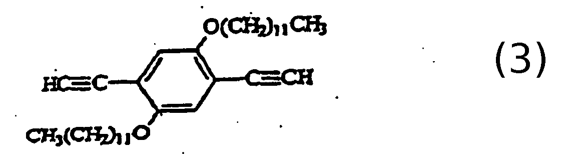

The 4-dodecyloxy-1,3-diethynylbenzene is given by a following chemical formula (4).

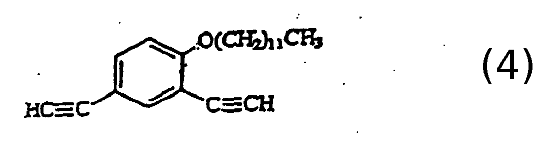

The THF reactive solution obtained by the oxidative condensation polymerisation reaction is concentrated to about 10 ml, and then the concentrate is dropped into 1-litre of 2N-HCl/MeOH solution that is hardly stirred. Then, the polymer generated by the oxidative condensation polymerisation reaction is precipitated in the 2N-HCl/MeOH solution, the catalyst is removed, and the polymer is purified.

Then, the precipitated polymer is recovered by using a glass filter, and a small amount of the polymer is dissolved once again in 10ml of the THF solution and then the polymer is reprecipitated by dropping such polymer into a large amount, e.g., 1 litre, of MeOH liquid. The MeOH liquid is strongly stirred.

The product is again refined by filtration of the reprecipitated polymer by using a glass filter. Then, the polymer is dried by the vacuum drying. The yield was 95%.

Equation (5) shows the reaction between the above 2,5-didodecyloxy-1,4-diethynylbenzene and the 4-dodecyloxy-1,3-diethynylbenzene to obtain the intended polymer.

In the reaction formula, "cat." denotes the catalyst. The copolymerization ratio of the polymer is given as x:y=1:1 similarly to the ratio of supply of the substances of chemical formulae (2), (3) as confirmed by the yield, and thus a polymer in which n the chemical formula (2) is 0.5 can be obtained. 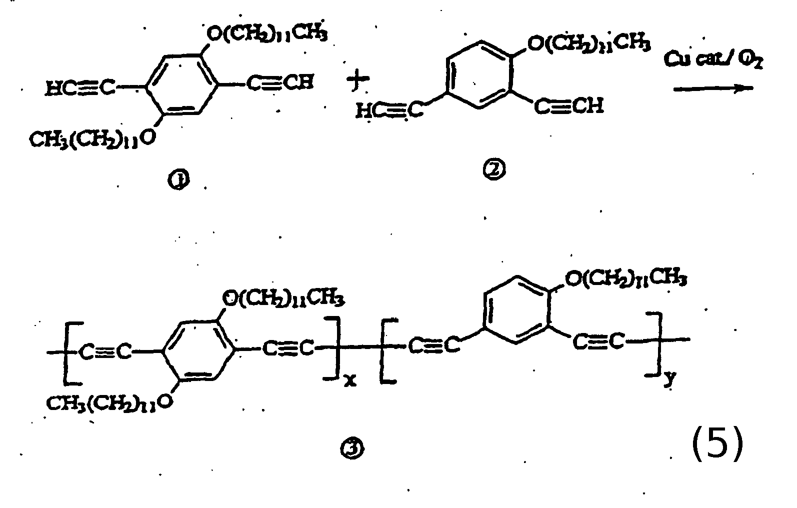 The polymer indicated by ③ in the reaction formula (5) is the structure obtained in the synthesis, and is the same substance as the polymer of chemical formula (2).

In the above example, the polymer given by the chemical formula (2) is employed as the luminous layer 3 of the organic EL device. A general formula for the polymer can be given by the following chemical formula (6).

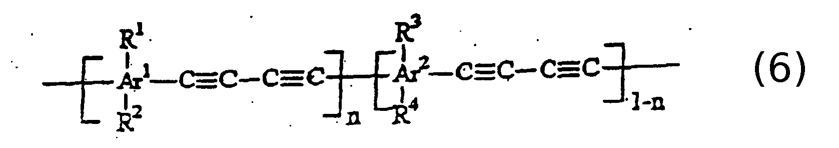

In the chemical formula (6), Ar¹ and Ar² each denote an arylene group (bivalent aromatic ring). Examples of the aromatic ring comprised by the term arylene group are benzene, pyrrole, thiophene, carbazole, furan, fluorene, naphthalene, anthracene, and derivatives thereof. The first unit which includes Ar¹ has two carbon-carbon triple bonds, and the second unit which includes Ar² also has two carbon-carbon triple bonds.

Specific arylene groups can be, for example, biphenyl, terphenyl, perylene, coumarin, diphenylamine, triphenylamine, phenanthrene, phenanthridine, phenanthroline, phenylazobenzene, diphenylazobenzene, anthraquinone, acridinone, quinacridone, stilbene, and derivatives of them.

The simplest arylene groups Ar¹ will be based on benzene and naphthalene as with 1,4-phenylene and 1,5 naphthalene groups, the latter enhancing the rigidity of the polymer. With Ar², the arylene group can be 1,3-phenylene or 1,2 naphthalene group, the latter having a structure to reduce the rigidity of the polymer.

R¹, R², R³, R⁴ are substituents such as hydrogen, alkyl, alkoxy, carboxyl, cyano, phenyl, biphenyl and cyclohexylphenyl. Also, R¹, R², R³, R⁴ can be the same or different or just some can be the same.

n in the chemical formula (6) is a copolymerization ratio and preferably n is set to 0<n≤0.9. As a polymer having n=1, for example, there is polyarylene butadienylene. In this case, it has been confirmed that the crystallinity at ambient temperature is relatively low and the solubility relatively high compared to the prior art.

The emission wavelength of the luminous layer 3 is changed by selecting R¹, R², R³, R⁴, Ar¹, Ar² appropriately. Accordingly, if a color image is needed, a pattern in which the structure of the polymer is changed for every pixel of the image is formed.

In order to finely adjust the luminous color of the luminous layer 3, a plurality of kinds of polymer may be contained.

In the chemical formula (6), the first unit can be defined as A and the second unit can be defined as B. Then, if A and B have the structures given by the chemical formula (2), i.e., if unit A has the structure of the para-substitution product and unit B has the structure of the meta-substitution product, a relationship between the copolymerization ratio n of the polymer constituting the luminous layer 3 given by the chemical formula (2) and the luminous intensity of the luminous layer 3 exists which has been examined experimentally. As a result, it has been found that, if the film thickness of the polymer and the forming steps are not changed, the luminous intensity differs according to difference in the value of n. In the case of n=0.66, or n:(1-n)=2:1, the luminous intensity of the luminous layer 3 was the highest.

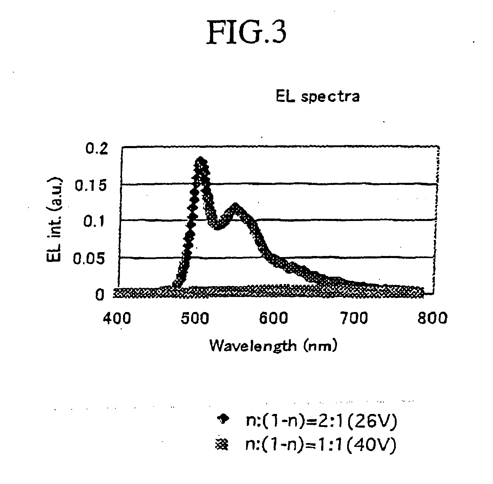

When the luminous intensities of the luminous layers 3 formed by the polymer of chemical formula (2) obtained when n:(1-n)=2:1 and that obtained when n:(1-n)=1:1 is set in the chemical are compared with each other, the EL spectrum shown in FIG.3 was derived. The profile showing the relationship between the luminous wavelength and the EL intensity is reflective of a profile of the fluorescent spectrum shown in FIG.2.

In FIG.3, the driving voltage of the luminous layer 3 formed of the polymer of n=0.5 is set to 40 V and the driving voltage of the luminous layer 3 formed of the polymer of n=0.66 is set to 26 V. Although there exists such difference in the driving voltage, the polymer of n=0.66 could provide an emission that is about 40 times as strong as that of the polymer of n=0.5.

In order to get n=0.66 in the chemical formula (2), i.e. to set x=2, y=1 in the chemical formula (5), 2.96 g (6 mmol) of the para-product indicated by a symbol ① in the chemical formula (5) and 0.93g (3 mmol) of the meta-product indicated by a symbol ② in the chemical formula (5) as the ratio of supply are dissolved in the tetrahydrofuran solution to cause the oxidative condensation polymerisation reaction. Then, like the case where the polymer of n=0.5 is formed, processes such as catalyst removal, polymer refinement, filtration/recovery, polymer reprecipitation, filtration/recovery, vacuum drying, etc. are carried out sequentially as before.

In the above organic EL device, a structure that outputs the light from the glass substrate side is employed. In contrast, the light may also be outputted from the upper side by reversing the structure of the electrodes and forming the light transparent conductive film on the upper side. Also, in the above organic EL device, a structure in which the luminous layer is directly put between a pair of electrodes is shown. In this case, an organic electron transmitting layer may be formed between the luminous layer and the negative side electrode, otherwise an organic hole transmitting layer may be formed between the luminous layer and the positive side electrode.

In the meanwhile, the polymer given by the chemical formula (2) can emit light in the emitting wavelength range of 500 to 550 nm, i.e., at green or near green color wavelengths.

In order to display a full color image on the display device, polymers that can emit red color light and blue color light are also required. A polymer embodying the present invention, that can emit light in the red color wavelength band, will now be explained.

First, the copolymerized polymer used as red color luminous layer 3 is given by the chemical formula (1). In the copolymerized polymer in the chemical formula (1), the aromatic ring Ar¹ in the chemical formula (6) now denotes a benzene ring, substituent R⁴. denotes a hydrogen atom, and Ar² denotes an arylene group, in which the aromatic ring is any one of thiophene, anthracene, pyridine, phenol, aniline, and derivatives thereof. In the chemical formula (1), R¹, R², R³, and R⁴ generally can be any one of hydrogen, alkyl, alkoxy, carboxyl, cyano, phenyl, biphenyl, and cyclohexylphenyl. As before, m and k denote copolymerisation ratio, and n denotes degree of polymerisation.

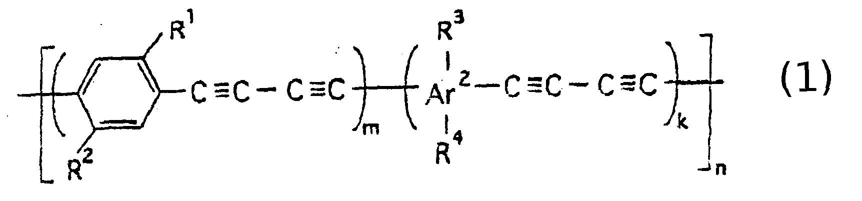

A polymer of chemical formula (1) in which R¹, R² are both alkoxy groups, the aromatic ring constituting Ar² is thiophene, R³ is carboxyl group, and R⁴ is hydrogen is copoly(2,5-didodecyloxy-1,4-phenylenebutadiynylene)(3-dodecyloxycarbonylthienylenebutadiynylene)(2: 1), and is given by (7)

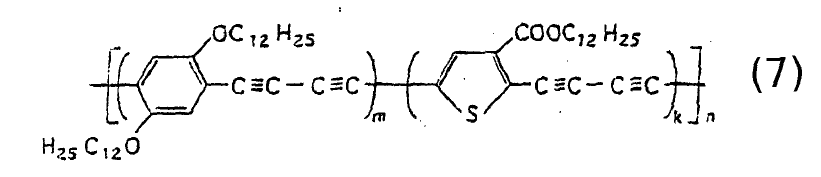

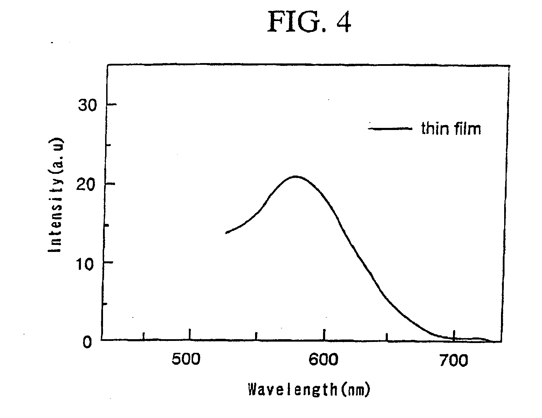

A luminous layer 3 formed of this copolymer given by the chemical formula (1) has the spectrum shown in FIG.4, and the peak in the luminous wavelength band is 574 nm.

The polymer given by the chemical formula (7) can be synthesised in the same manner as mentioned above by using 3-dodecyloxycarbonyl-2,5-bis(trimethylsilylethynyl)thiophene in place of 4-dodecyloxy-1,3-diethynylbenzene having the chemical formula (4).

As described above, according to the present invention, a luminous layer made of the polymer of formula (1) is formed between the lower electrode and the upper electrode. In contrast to the polymers employed as the luminous layer the prior art, such polymer is hard to crystallize at ambient temperature and has a high solubility in solvents.

Accordingly, if this polymer is employed as the luminous layer, planarization of the luminous layer can be facilitated, short-circuiting between the upper electrode and the lower electrode hardly occurs, and the yield of the device can be improved.

Also, if a polymer is synthesised such that the substitution ratio of the para-product and the meta-product is set to x : y = 2 : 1 in the chemical formula (5), a luminous layer that can provide a particularly strong emission can be obtained.

## Claims

1. An organic luminous material having the general formula 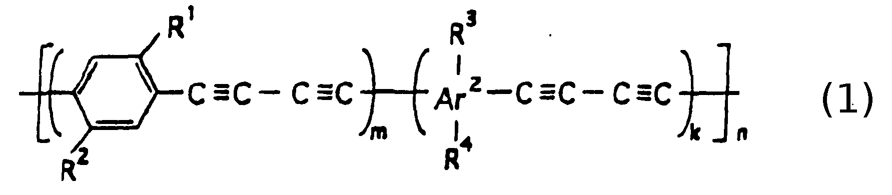 where Ar² denotes an arylene group, R¹, R², R³ and R⁴ denotes substituents, which can be the same or different or some of which can be the same and other(s) different and m and k together denote the copolymerization ratio and n denotes the degree of polymerisation;
wherein an aromatic ring comprised by the arylene group is any one of thiophene, anthracene, pyridine, phenol, aniline and derivatives thereof, and the said substituents are selected from hydrogen, alkyl, alkoxy, carboxyl, cyano, phenyl, biphenyl and cyclohexylphenyl; and
wherein 0<m<1, m+k=1.

2. An organic light-emitting device comprising:
a lower electrode;
a luminous layer formed on the lower electrode, which is the organic luminous material as claimed in claim 1; and
an upper electrode formed on the luminous layer.

## Patentansprüche

1. Organischer Leuchtstoff mit der allgemeinen Formel: 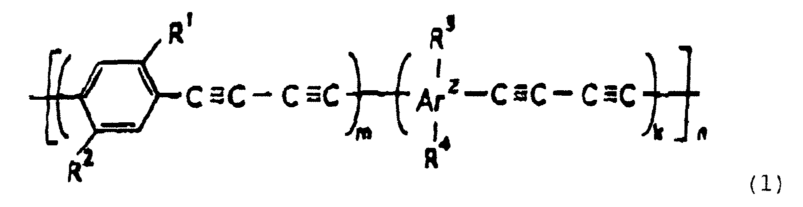 wobei Ar² eine Arylengruppe bezeichnet, R¹, R², R³ und R⁴ Substituenten bezeichnen, die die gleichen oder verschieden sein können oder von denen einige die gleichen und ein anderer (die anderen) verschieden sein können, und m und k zusammen das Copolymerisationsverhältnis bezeichnen und n den Polymerisationsgrad bezeichnet;
bei dem ein aromatischer Ring, der aus der Arylengruppe gebildet ist, einer von Thiophen, Anthracen, Pyridin, Phenol, Anilin und Derivaten derselben ist und die Substituenten ausgewählt sind aus Wasserstoff, Alkyl, Alkoxy, Carboxyl, Cyano, Phenyl, Biphenyl und Cyclohexylphenyl; und
bei dem 0<m<1, m+k=1 ist.

2. Organische lichtemittierende Anordnung mit:
einer unteren Elektrode;
einer Leuchtschicht, die auf der unteren Elektrode gebildet ist und der organische Leuchtstoff nach Anspruch 1 ist; und
einer oberen Elektrode, die auf der Leuchtschicht gebildet ist.

## Revendications

1. Matériau lumineux organique ayant la formule générale 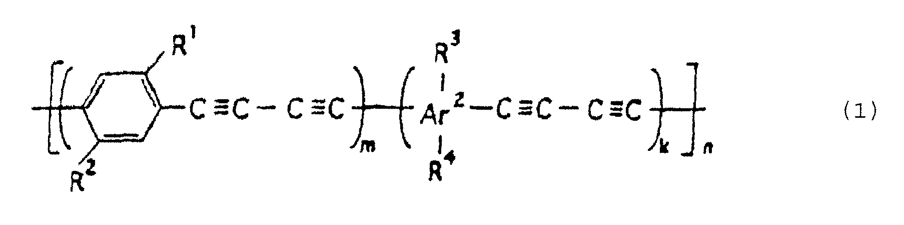 où Ar² désigne un groupe arylène, R¹, R², R³ et R⁴ désignent des substituants qui peuvent être identiques ou différents ou certains d'entre eux peuvent être identiques et d'autres différents, et m et k désignent le rapport de copolymérisation et n désigne le degré de polymérisation ;
où un cycle aromatique constitué par le groupe arylène est l'un quelconque parmi le thiophène, l'anthracène, la pyridine, le phénol, l'aniline et leurs dérivés, et lesdits substituants sont choisis parmi un atome d'hydrogène, les groupes alkyle, alcoxy, carboxyle, cyano, phényle, biphényle et cyclohexylphényle ; et
où 0 < m < 1, m + k = 1.

2. Dispositif électroluminescent organique comprenant :
une électrode inférieure ;
une couche lumineuse formée sur l'électrode inférieure qui est le matériau lumineux organique selon la revendication 1 ; et
une électrode supérieure formée sur la couche lumineuse.
